Europäisches Patentamt

**European Patent Office**

**Office européen des brevets**

(11) Publication number: **0 144 141**

**A1**

# (12) EUROPEAN PATENT APPLICATION

(21) Application number: **84307334.7**

(22) Date of filing: **25.10.84**

(51) Int. Cl.⁴: **H 01 L 29/10**
**H 01 L 29/60**

(30) Priority: **21.11.83 GB 8331028**

(43) Date of publication of application:
**12.06.85 Bulletin 85/24**

(84) Designated Contracting States:
**DE FR IT SE**

(71) Applicant: WESTINGHOUSE BRAKE AND SIGNAL
COMPANY LIMITED
Pew Hill
Chippenham Wiltshire(GB)

(72) Inventor: Garrett, John Mansell
17 The Parklands Hullavington
Chippenham Wiltshire, SN14 3DL(US)

(74) Representative: Bird, Vivian John et al,
PAGE & CO. Temple Gate House
Temple Gate Bristol, BS1 6PL(GB)

(54) Disseminated gate thyristor.

(57) A conventional distributed gate structure (8) in an amplifying gate thyristor is not always effective in "turning-on" the whole cathode region (7) when the initial current gradient is low. Consequently the distributed structure (8) can actually impede instead of assist subsequent spreading of conduction. The solution is to create a multiplicity of disseminated zones (Z) which "turn-on" preferentially at low current levels so that cathode conduction spreads out from many points simultaneously instead of from only very few.

FIG.2a

EP 0 144 141 A1

Disseminated Gate Thyristor

The invention relates to thyristors of the amplifying gate type.

Amplifying gate thyristor devices are often provided with a distributed gate structure having an extended gate length which assists "turn-on" of the device by encouraging the spread of conduction.

Physically large high powered devices, i.e. devices which are large in terms of lateral dimensions, have conduction spreading times, in the absence of distribution, of approximately 1 ms. Whereas the distributed gate structure of these devices is effective at high frequency and/or high rates of current rise, a problem may arise in conditions of low initial current increase, i.e. of the order of less than 10 A/µs, when the internal amplified signal may, in the presence of any non-uniformity of device manufacture, turn on only part of the cathode area adjacent the distributed electrode. Subsequently conduction spreading can then be impeded rather than encouraged by the distributed gate structure.

The present invention seeks to overcome this problem by providing a gate structure which initiates conduction at a multiplicity of points scattered over the area of the cathode.

According to the present invention there is provided an amplifying gate thyristor in which an auxiliary cathode region is connected to a distributed gate structure interdigitated with a main cathode region for the purpose of laterally distributing amplified gate signals, wherein in the region between adjacent edges of the main cathode region and the

distributed gate structure are formed a multiplicity of disseminated zones of alternately different resistance values which provide preferred and deferred conduction paths for amplified gate signals.

The invention and how it may be carried into practice will now be described, by way of example only, with reference to several embodiments illustrated in the accompanying drawings, in which:

Fig 1 (a) shows a plan view of a prior art distributed gate thyristor,

Figs 1 (b) and (c) show cross-sections through the device of fig 1 on lines A - A and B - B respectively,

Figs 2 (a) and (b) show alternative forms of a first embodiment of the invention,

Fig 3 shows a second embodiment,

Fig 4 shows a third embodiment,

Fig 5 (a) shows a fourth embodiment, which is effectively a combination of the first and third embodiments,

Fig 5 (b) is a section through part of the device of Fig 5 (a) on line X - X of fig 5 (a).

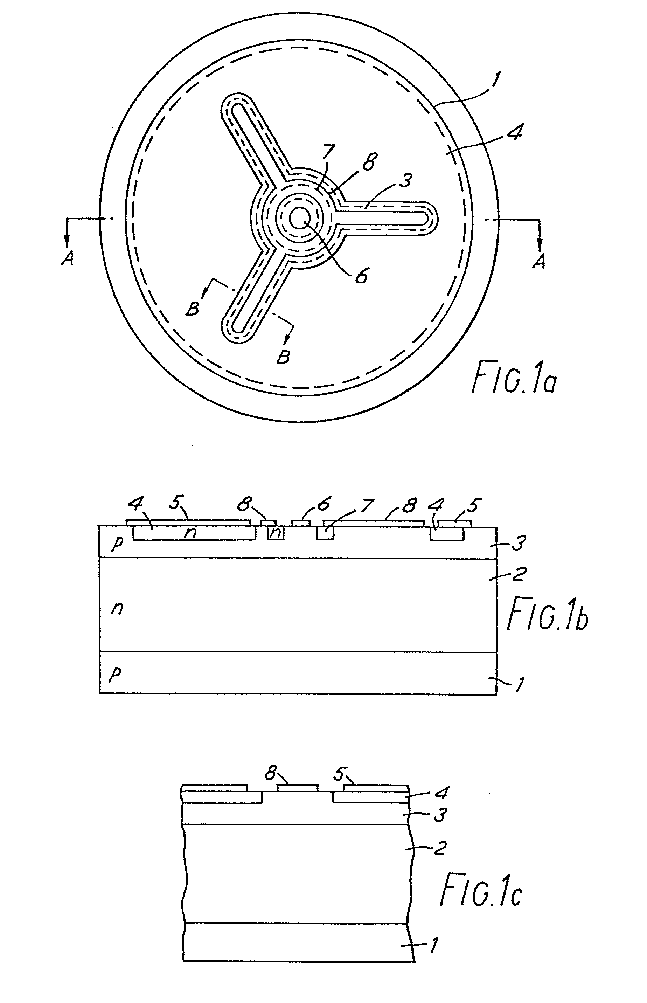

Referring now to the drawings, in figs 1 a, b and c there is shown a thyristor device having four semiconductor layers of alternating conductivity type, the anode layer is indicated by reference 1, the n-base layer by reference 2, the p-base layer by 3, and the cathode by reference 4. The cathode electrode is shown at reference 5 and the primary gate electrode at 6. Lying between these is an auxiliary cathode region 7 and a distributed gate structure 8 which partially overlaps both the auxiliary cathode region 7 and the p-base layer 3.

Fig 1(a) shows the thyristor device to be generally circular with the primary gate electrode 6 positioned at its centre, and the auxiliary cathode 7 formed by an annular ring concentric with the electrode 6. The distributed gate structure 8 consists of a further concentric annulus, of inner and outer radii respectively slightly greater than those of the auxiliary cathode region 7, and equi-angularly spaced elongate radial arms extending therefrom. The central annular portion of this gate electrode partially overlaps the auxiliary cathode 7 and the surrounding p-base layer 3. The main cathode electrode 5 extends over almost all of the remaining surface of the thyristor except for a narrow strip adjacent the outside edge of the distributed gate 8 and the outermost periphery of the device, this cathode electrode 5 also overlaps the outer edge of the cathode region 4 on to the base layer 3.

The operation of this type of amplifying gate thyristor device is well understood and documented and will not, for the sake of brevity, be repeated here.

The remaining figures of the drawings show improvements, according to the invention, of the basic device described above with reference to figs 1a, 1b and 1c and in which like parts are given like references.

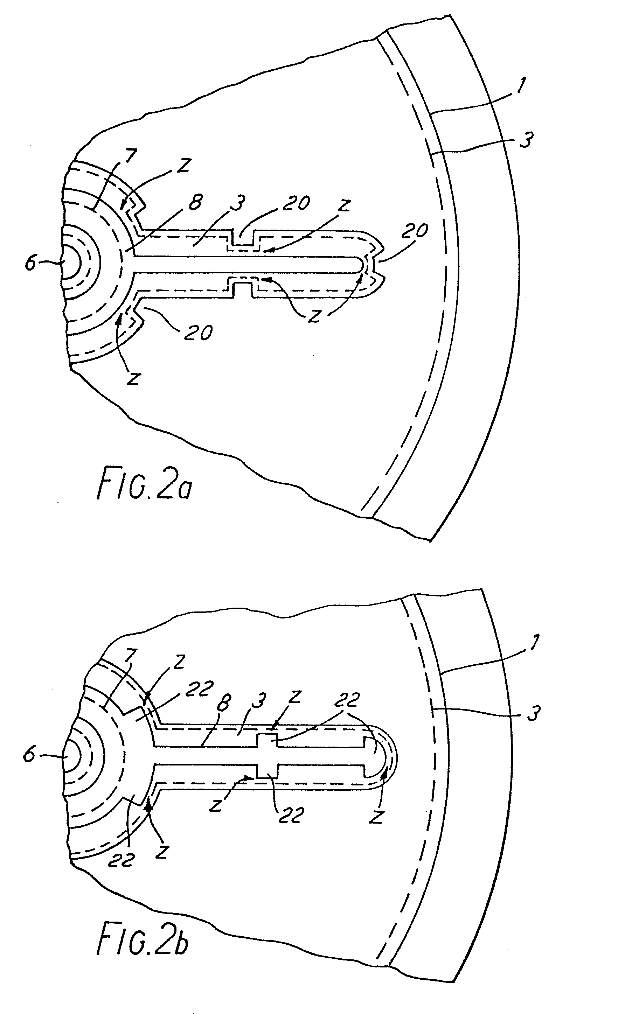

Referring now to figs 2a and 2b there is shown a first form of the invention in which the preferred and deferred conduction paths through the base layer 3, in the region between the edges of the main cathode 4 and the distributed gate 8, are brought about by variations in the spacing between adjacent edges of these parts. In fig 2a portions of the inner edge of the main cathode electrode 4 are relatively recessed, i.e. spaced at a greater distance, from the adjacent edge of the distributing gate 8. This configuration leaves unrecessed portions or tabs, indicated by references 20 which remain apparently projecting from the main electrode 4 towards the gate 8 so that there is formed between these two parts a relatively narrower zone generally indicated by reference Z. These tabs 20 are spaced apart around the inner edge of the cathode electrode 4 so as to form a multiplicity of such zones Z scattered along the length of the region lying between the electrodes 4 and 8.

The form of invention illustrated in fig 2b is effectively the same as in fig 2a but in practice has the inverse physical form. In this the inner perimeter of the cathode electrode 4 is unbroken and the distributed gate 8 is formed with edge recesses which alternate around its entire edge length with unrecessed portions thereby forming tabs 22, which approach more closely to the cathode 4 forming between them further zones indicated by references Z.

In both the forms of the invention, in zones Z there is a reduced conduction path length between the distributed gate 8 and the main cathode 4 so that these constitute preferred conduction paths for amplified gate signals. In operation of these thyristors therefore main conduction will strike first in the zones and surrounding areas and will spread outwardly therefrom. Conduction commences in these zones at relatively low levels of main circuit current (or anode current) so that even with slowly rising anode current conditions a multiplicity of points in the main cathode are "turned-on" immediately, and from each of these points conduction can spread more rapidly and effectively over the whole of the cathode area.

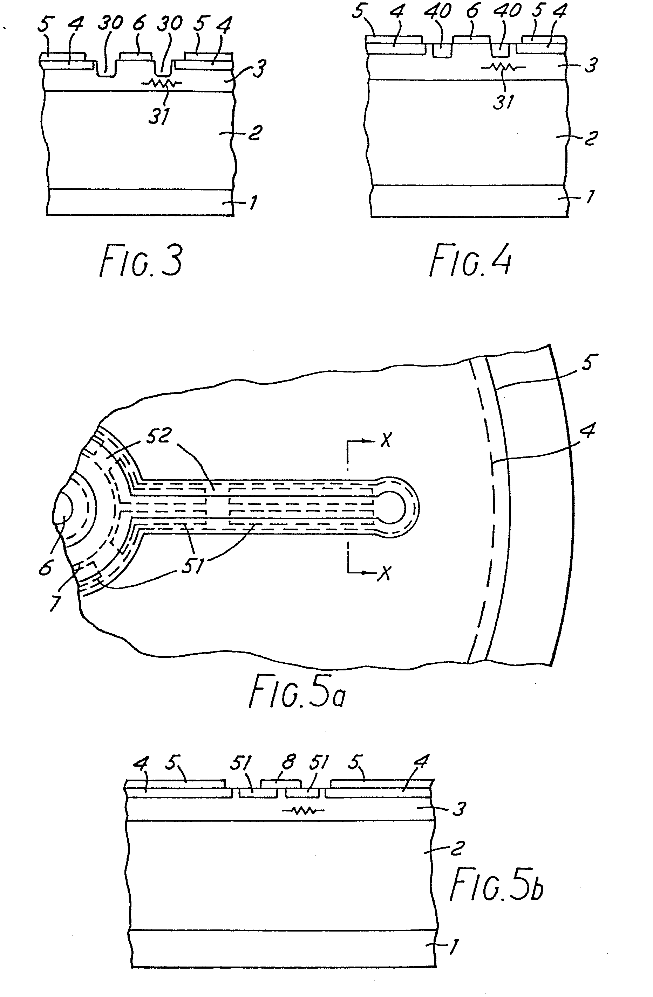

Fig 3 shows a further embodiment of the invention in which the effect of the recessed regions of figs 2a and 2b are alternatively achieved by forming niches, shown in cross-section at 30, by chemical etching or other equivalent process. Thus, a multiplicity of niches 30 are separated one from another by remaining lands (not shown) which form the zones Z of preferred conduction, since these now constitute less constricted and less resistive paths between gate 8 and electrode 4. The niches 30 are excavated to approximately half the depth of the base layer 3 so that a portion of the base layer extending under the recesses remains unaffected. Therefore, in the conduction path through the base layer 3 between gate 8 and cathode 4 the conduction path under the niches 30 is decreased in thickness relative to that through the lands and the path resistance 31 below the niches 30 is increased by reason of the reduced cross-section of the remaining part of the base layer 3.

In the third form of the invention, illustrated in fig 4, the deferred zones of conduction are formed by regions 40 in the base layer 3 into which an impurity of opposite conductivity type has been in-diffused to a partial depth of the base layer. These regions 32 alternate with other regions masked from the additional diffusion process which are equivalent to the lands referred to in fig 3, and the tabs in figs 2a and

2b.

The form of the invention illustrated in figs 5a and 5b is effectively a combination of the two forms illustrated in figs 2a, 2b and fig 4. Regions 51 of n-type impurity are formed partially underlying the edges of the distributed gate electrode 8 by diffusion at the same time as for example the cathode 4. The regions 51 effectively mask the overlying length of the edges of gate electrode 8. Thus, the path length between the gate electrode 8 and cathode 4 is increased in the vicinity of the regions 51 and the base-layer 3 is reduced in thickness at the same time.

In the spaces 52 between the regions 51 lie regions of unaffected base layer which constitute preferred regions for conduction strike during initial phases of a "turn-on" operation. The regions 51 do not actively participate in functioning of the device since during the times in question the gate electrode 6 is postively biased relative to the cathode electrode 5, and therefore each pn junction formed by a common boundary between p-base layer 3 and n-type regions 51 is reverse biased.

Under stressful turn-on conditions, that is, where the initial increase of current in the anode circuit ($^{dI}/dt$) is of the order of 100 A/μs or greater, the amplified gate signal will be correspondingly increased and the current in the deferred conduction paths (i.e. the higher resistance regions described above) may still be great enough to turn-on the adjacent cathode edge. This is desirable and may be facilitated by arrangement of relative resistances in the preferred and deferred paths.

Intermediate levels of switching between switching only in the zones corresponding to the paths and switching everywhere can be achieved with transitionary or less deferred zones which are brought into operation by turn-on conditions more stressful than those which will switch only the preferred path zones. Several levels of transitionary zones may be employed so that in addition to first deferred zones there may be second and subsequently switched deferred zones which turn-on under progressively more stressful conditions. Theoretically there is no limit to the gradation of zone sensitivity right up to continuous gradation, but in practice the three differential zones mentioned, that is the peferred, deferred and one intermediate level are found to be sufficient.

Claims

1. An amplifying gate thyristor in which an auxiliary cathode region (7) is connected to a distributed gate structure (8) interdigitated with a main cathode region (4) for the purpose of laterally distributing amplified gate signals, characterised in that in the region between adjacent edges of the main cathode region (4) and the distributed gate structure (8) are formed a multiplicity of disseminated zones (Z) of alternately different resistance values (31) which provide preferred and deferred conduction paths for amplified gate signals.

2. A thyristor according to Claim 1 further characterised in that the different resistance values (31) are provided by different spacings in the disseminated zones (Z) between adjacent edges (20 Fig. 2a, 22 Fig. 2b) of the main cathode region (3) and the distributed gate structure (8).

3. A thyristor according to Claim 1 further characterised in that the different resistance values (31) are provided by different thicknesses of the semiconductor regions in the disseminated zones.

4. A thyristor according to Claim 3 further characterised in that in alternate zones of different thickness, the reduced thickness is provided by a groove (30) formed in the semiconductor material in the zone.

5. A thyristor according to Claim 4 further characterised in that the groove (3) is formed by etching.

6. A thyristor according to any preceding claim further characterised in that there is diffused into

0144141

the semiconductor material (3) in the region of a disseminated zone (Z) an impurity of opposite conductivity type whereby to provide a zone (40) of different resistance value.

0144141

FIG.1a

FIG.1b

FIG.1c

FIG.2a

FIG.2b

0144141

Fig.3

Fig.4

Fig.5a

Fig.5b

**European Patent Office**

**EUROPEAN SEARCH REPORT**

Application number

EP 84 30 7334

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| A | DE-A-3 032 768 (BROWN, BOVERI & CIE.AG.)<br><br>* Page 3, line 1 - page 4, line 3; figure *<br><br>--- | 1,2 | H 01 L 29/10<br>29/60 |
| A | DE-A-1 954 665 (LICENTIA PATENT-VERWALTUNGS GmbH)<br><br>* Claims 1-5; figure 2 *<br><br>--- | 1 | |
| A | DE-A-2 341 211 (LICENTIA PATENT-VERWALTUNGS GmbH)<br><br>* Claims 1-8; figure 1 *<br><br>--- | 1 | TECHNICAL FIELDS SEARCHED (Int Cl 4) |
| A | US-A-3 611 066 (R. KNAUS)<br><br>----- | | H 01 L |

The present search report has been drawn up for all claims

| Place of search | Date of completion of the search | Examiner |
|---|---|---|
| THE HAGUE | 13-02-1985 | ZOLLFRANK G. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03 82